# EUROPÄISCHE PATENTSCHRIFT

(11) **EP 1 000 425 B1**
(45) Veröffentlichungstag und Bekanntmachung des Hinweises auf die Patenterteilung: **06.09.2006**
(21) Anmeldenummer: 98942596.2
(22) Anmeldetag: 22.07.1998
(51) Int. Cl.: G11B 9/00, G03F 7/20, G01N 27/00

(54) **VERFAHREN ZUR NANOSTRUKTURIERUNG VON AMORPHEN KOHLENSTOFFSCHICHTEN**
METHOD FOR NANO-STRUCTURING AMORPHOUS CARBON LAYERS
PROCEDE DE NANOSTRUCTURATION DE COUCHES DE CARBONE AMORPHES

(30) Priorität: 02.08.1997 DE 19733520
(43) Veröffentlichungstag der Anmeldung: 17.05.2000
(73) Patentinhaber: Leibniz-Institut für Festkörper- und Werkstoffforschung Dresden e.V., 01069 Dresden (DE)
(72) Erfinder: MÜHL, Thomas, D-01159 Dresden (DE); REISS, Günter, D-33602 Bielefeld (DE); BRÜCKL, Hubert, D-33613 Bielefeld (DE)
(74) Vertreter: Rauschenbach, Dieter
(86) Internationale Anmeldenummer: PCT/EP1998/004600
(87) Internationale Veröffentlichungsnummer: WO 1999/006996

(56) Entgegenhaltungen:
- WO-A-96/24887
- US-A- 4 896 044
- US-A- 5 416 331
- UESUGI K ET AL: "Nanometer-scale process technology on graphite surfaces by scanning tunneling microscope" EXTENDED ABSTRACTS OF THE 1991 INTERNATIONAL CONFERENCE ON SOLID STATE DEVICES AND MATERIALS, YOKOHAMA, JAPAN, 27-29 AUG. 1991, Seiten 678-679, XP002088621 1991, Tokyo, Japan, Bus. Center Acad. Soc. Japan, Japan
- WANG D ET AL: "LITHOGRAPHY USING ELECTRON BEAM INDUCED ETCHING OF A CARBON FILM" JOURNAL OF VACUUM SCIENCE AND TECHNOLOGY: PART B, Bd. 13, Nr. 5, 1. September 1995, Seiten 1984-1987, XP000555604 in der Anmeldung erwähnt
- YAU S T ET AL: "NANOFABRICATION WITH A SCANNING TUNNELING MICROSCOPE" JOURNAL OF APPLIED PHYSICS, Bd. 69, Nr. 5, 1. März 1991, Seiten 2970-2974, XP000224893
- ABE T ET AL: "NANOMETER-SCALE PITE FORMATION BY SCANNING TUNNELING MICROSCOPY ON GRAPHITE SURFACE AND TIP CURRENT MEASUREMENTS" JOURNAL OF APPLIED PHYSICS, Bd. 75, Nr. 2, 15. Januar 1994, Seiten 1228-1230, XP000425477
- CAMPBELL P M ET AL: "PROXIMAL PROBE-BASED FABRICATION OF NANOSTRUCTURES" SEMICONDUCTOR SCIENCE AND TECHNOLOGY, Bd. 11, Nr. 11S, November 1996, Seiten 1558-1562, XP000630339
- HOSAKA S ET AL: "FABRICATION OF NANOMETERSCALE STRUCTURES ON INSULATORS AND IN MAGNETIC MATERIALS USING A SCANNING PROBE MICROSCOPE" JOURNAL OF VACUUM SCIENCE AND TECHNOLOGY: PART B, Bd. 13, Nr. 3, Mai 1995, Seiten 1307-1311, XP000537397
- ALBRECHT R.T. ET AL: 'Nanometer-scale hole formation on graphite using scanning tunneling microscope' APPLIED PHYSICS LETTER Bd. 55, Nr. 17, 23 Oktober 1989, Seiten 1727 - 1729, XP000099938

## Beschreibung

### Technisches Gebiet

Die Erfindung bezieht sich auf das Gebiet der Herstellung oder Behandlung von Halbleiter- oder anderen Festkörperbauelementen und betrifft ein Verfahren zur Nanostrukturierung von amorphen Kohlenstoffschichten.

Das Verfahren ist vorteilhaft bei der Herstellung elektronischer Bauelemente im Sub-µm-Bereich und im nm-Bereich anwendbar und eignet sich dort insbesondere zum Erzeugen nanostrukturierter Ätzmasken, deren Struktur auf darunterliegende Schichten übertragen werden sollen. Außerdem kann das erfindungsgemäße Verfahren für das Eintragen von Information in amorphen Kohlenstoffschichten für den Zweck der Speicherung von Informationen angewandt werden.

### Stand der Technik

Bisher werden Masken, die zur Strukturübertragung in darunterliegende Schichten durch Ätzen bzw. zur Anwendung des Lift-off-Verfahrens dienen sollen, mit Photo- und mit Elektronenstrahl-Lithographie hergestellt. Außerdem sind verschiedene Möglichkeiten bekannt, mit Rastersondenmikroskopen Strukturen mit Strukturgrößen im Bereich von Nanometern zu erzeugen. So können zum Beispiel mit Rastertunnelmikroskopen elektronenstrahlempfindliche Lacke belichtet werden (E. A. Dobisz and C. R. K. Marrian, Appl. Phys. Lett. 58, 2526 (1991)), und Rasterkraftmikroskope (RKM) werden zum mechanischen Modifizieren von Schichten (V. Bouchiat and D. Esteve, Appl. Phys. Lett. 69, 3098 (1996)) oder von metallischen Leiterbahnen (R. Rank, H. Brückl, J. Kretz, I. Mönch, and G. Reiss, Vacuum 48, 467 (1997))sowie zur feldinduzierten, lokalen Oxidation von Silizium verwendet (C. Schönenberger, N. Kramer, Microelectron. Eng. 32, 203 (1996))

Innerhalb der Gruppe der anorganischen Resistmaterialien belegen amorphe Kohlenstoff-Schichten einen wichtigen Platz (K. Kragler, E. Günther, R. Leuschner, G. Falk. A. Hammerschmidt, H. von Seggern, and G. Saemann-Ischenko, Appl. Phys. Lett. 67, 1163 (1995)). Vorteile sind u. a.: Die Reaktionsfreudigkeit des amorphen Kohlenstoffs mit den meisten Substraten ist vernachlässigbar, amorpher Kohlenstoff ist widerstandsfähig gegen Halogen-Plasma, so daß strukturierte Kohlenstoff-Filme als Ätzmaske für das Halogen-Plasma-Ätzen zur Strukturübertragung in darunter liegende Schichten geeignet sind. Kohlenstoff-Filme können problemlos mittels reaktivem Ionen-Ätzen mit Sauerstoff oder Wasserstoff entfernt werden.

Es ist bekannt, daß amorphe Kohlenstoffschichten strukturiert werden können, indem die Struktur einer über dem Kohlenstoff liegenden Schicht in den Kohlenstoff durch Ätzen übertragen wird.

Bekannt ist auch die direkte Strukturierung amorpher Kohlenstoff-Filme mittels Ätzen im Elektronenstrahl in einer definierten Sauerstoffumgebung. Mit dieser Methode wurden Strukturgrößen bis hinab zu 0,5 µm erreicht (D. Wang, P. C. Hoyle, J. R. A. Cleaver, G. A. Porkolab, and N.C. MacDonald, J. Vac. Sci. Technol. B 13, 1984 (1995)). Hierbei sind die Reaktionsprodukte zwar in vorteilhafter Weise flüchtig, jedoch besteht ein wesentlicher Nachteil dieses Verfahrens darin, daß auf diese Weise erzeugte Strukturen im amorphen Kohlenstoff nicht in darunter befindliche Siliziumsubstrate übertragen werden können, da bei der Strukturierung eine ätzresistente Schicht an der Siliziumoberfläche entsteht.

Es ist auch bekannt, "diamond-like carbon"-Filme im Fokus eines Lasers lokal zu graphitisieren und durch Nutzung der unterschiedlichen Sauerstoff-Plasma-Ätzraten von Graphit und "diamond-like carbon" Masken herzustellen. Auf diese Weise konnten Strukturen mit Größen im Bereich von 5 µm erzeugt werden (J. Seth, S. V. Babu, V. G. Ralchenko, T.V. Kononenko, V. P. Ageev, and V. E. Strelnitsky, Thin Solid Films, 254, 92 (1995)).

### Darstellung der Erfindung

Der Erfindung liegt die Aufgabe zugrunde, in amorphen Kohlenstoffschichten auf dem Wege einer direkten Strukturierung Strukturen mit Größen im Bereich von Nanometern zu erzeugen.

Diese Aufgabe ist mit dem in den Patentansprüchen beschriebenen Verfahren zur Nanostrukturierung von amorphen Kohlenstoffschichten gelöst.

Dabei wird erfindungsgemäß mit einer elektrisch leitfähigen oder halbleitenden Sonde, die sich in einem Abstand, in dem der elektrische Leitungsmechanismus der Feldemission oder des Tunnelns möglich ist, über der amorphen Kohlenstoffschicht befindet oder über diese geführt wird, und an die eine elektrische Spannung gegenüber der Schicht angelegt wird, an den Stellen, an denen Vertiefungen in die Schicht eingebracht oder die Schicht entfernt werden soll, eine lokale, feldinduzierte Reaktion des Kohlenstoffs aktiviert. Die hierbei entstehenden Reaktionsprodukte sind in vorteilhafter Weise flüchtig, so daß ohne einen weiteren Technologieschritt die gewünschte Struktur entsteht.

Zweckmäßigerweise befindet sich die elektrisch leitfähige oder halbleitende Sonde in einem Abstand von bis zu 10 nm über der amorphen Kohlenstoffschicht oder wird über diese geführt.

Die an die Sonde angelegte elektrische Spannung kann erfindungsgemäß ein negatives Gleichspannungspotential mit einer Mindestspannung im Bereich von 3 bis 8 Volt gegenüber der Schicht oder eine Wechselspannung sein.

Entsprechend einer zweckmäßigen Ausgestaltung der Erfindung kann der Abstand zwischen der elektrisch leitfähigen oder halbleitenden Sonde und der amorphen Kohlenstoffschicht durch eine elektrisch isolierende Schicht von bis zu einigen Nanometern Schichtdicke, die sich auf der Oberfläche der Sonde befindet, definiert werden.

Erfindungsgemäß kann die Reaktion in einer Sauerstoffumgebung durchgeführt werden, wobei als Reaktionsprodukte Oxide des Kohlenstoffs entstehen, oder die Reaktion wird in einer Wasserstoff- oder einer Stickstoffumgebung durchgeführt.

Gemäß einer zweckmäßigen Ausgestaltung der Erfindung kann die Nanostrukturierung mittels eines Rastersondenmikroskops durchgeführt werden, wobei die elektrisch leitende oder halbleitende Sonde des Mikroskops zur feldinduzierten Reaktion des Kohlenstoffs verwendet wird.

Als elektrisch leitfähige Sonde kann erfindungsgemäß auch eine strukturierte Elektrode verwendet werden, deren Struktur als das Negativ der in der Schicht zu erzielenden Nanostruktur ausgeführt ist. Eine solche Elektrode arbeitet sich dann in die amorphe Kohlenstoffschicht ein und überträgt dabei ihre Struktur.

Entsprechend einer Ausgestaltung der Erfindung kann der Abstand zwischen der elektrisch leitfähigen oder halbleitenden Sonde und der amorphen Kohlenstoffschicht während der Strukturierung zeitlich periodisch verändert werden.

Entsprechend einer weiteren Ausgestaltung der Erfindung kann das negative Gleichspannungspotential während der Strukturierung auch zeitlich periodisch verändert werden.

Erfindungsgemäß kann auch eine elektrisch leitfähige oder halbleitende Sonde aus Silizium verwendet werden, wobei die Polarität des Gleichspannungspotentials während der Strukturierung in bestimmten Intervallen für bestimmte Zeit umgekehrt wird. Hierbei entsteht auf der Oberfläche der Sonde durch feldinduzierte Oxidation eine Schicht Siliziumoxid oder wird eine derartige Schicht wiederhergestellt.

Statt einer Gleichspannungsquelle kann nach der Erfindung auch eine Konstantstromquelle verwendet werden, wobei der Übergangswiderstand zwischen elektrisch leitfähiger oder halbleitender Sonde und der amorphen Kohlenstoffschicht so einzustellen ist, daß während der Strukturierung eine bestimmte Mindestspannung erreicht wird.

Die Erfindung sieht weiterhin vor, daß das erfindungsgemäße Verfahren für den Zweck der Speicherung digitaler oder analoger Informationen angewandt wird, indem mit der erfindungsgemäßen Nanostrukturierung in amorphe Kohlenstoffschichten solche Strukturen eingebracht werden, die digitale oder analoge Informationen repräsentieren.

Das erfindungsgemäße Verfahren zeichnet sich gegenüber dem Stand der Technik durch einige wesentliche Vorteile aus. Besonders vorteilhaft ist, daß in den Kohlenstoffschichten die Strukturen auf dem Wege einer direkten Strukturierung erzeugt werden können, da bei dem angewandten Verfahren die Reaktionsprodukte des Kohlenstoffs flüchtig sind. Vorteilhaft ist weiterhin, daß mit dem Verfahren präzise Strukturen mit Größen im Bereich von Nanometern erzeugt werden können. Darüber hinaus bietet das Verfahren Gestaltungsmöglichkeiten für die dritte räumliche Dimension der zu strukturierenden Schicht, das heißt, in die Tiefe der Schicht hinein.

Nachstehend ist die Erfindung an Hand von Ausführungsbeispielen und zugehörigen Abbildungen näher erläutert.

### Beispiel 1

Das Beispiel betrifft die Erzeugung eines Grabens in einer bei Raumtemperatur mit Argon RF-gesputterten amorphen Kohlenstoffschicht mit einem kommerziellen Rasterkraftmikroskop.

Als Sonde dient ein "contact mode"-Cantilever aus dotiertem Silizium-Einkristall mit einer Federkonstante von etwa 0.5 N/m. Sowohl die Probe mit der Schicht aus amorphem Kohlenstoff als auch der Cantilever werden elektrisch kontaktiert und mit einer regelbaren Konstantstromquelle verbunden, die aber zunächst noch ausgeschaltet ist.

Die Topographie der Probenoberfläche wird in dem zu strukturierenden Bereich im üblichen Abbildungsmodus des Rasterkraftmikroskopes aufgenommen. Mit Hilfe einer Lithographiesoftware wird die Linie definiert, entlang der ein Graben in den Kohlenstoff geschrieben werden soll. Der Cantilever wird zum Startpunkt der gewünschten Linie bewegt. Ab dem Zeitpunkt, wenn er sich mit einer gewählten Geschwindigkeit von z. B. 1 µm/s über die Kohlenstoffoberfläche entlang der programmierten Linie zu deren Endpunkt bewegt, wird der Gleichstrom zugeschaltet, wobei die Spannung an der Probe positiv gegenüber dem Cantilever ist. Die Spannung der Konstantstromquelle kann z. B. auf max. 10 Volt begrenzt werden, der Strom kann im Bereich weniger nA liegen. Die gewünschte Struktur kann ein- oder mehrmals abgefahren werden. Nach Abschluß der Strukturierung wird die Gleichspannung abgeschaltet.

Das Ergebnis der Strukturierung kann mittels einer Topographieaufnahme im üblichen Abbildungsmodus im gleichen Rasterkraftmikroskop mit der gleichen Sonde, die auch zur Strukturierung verwendet wurde, sofort nachgewiesen werden.

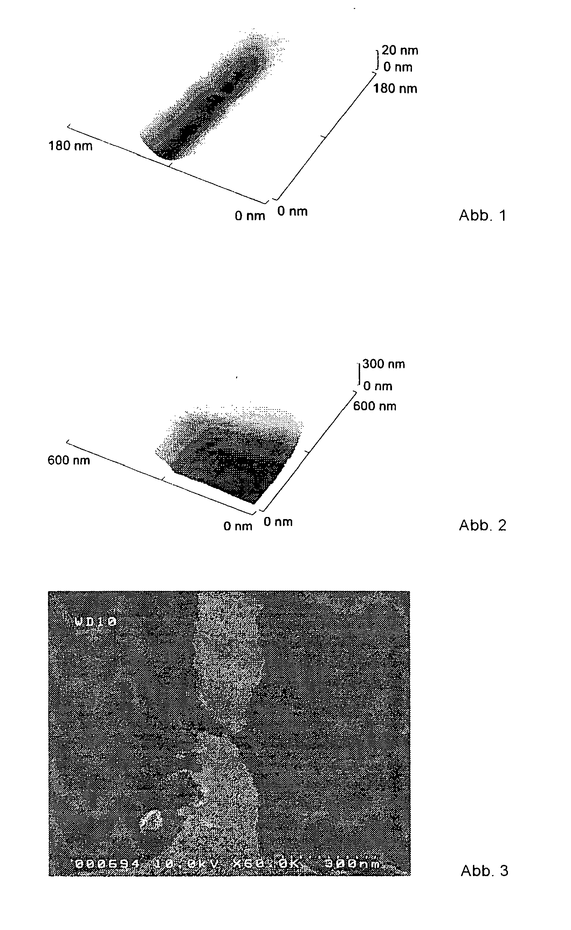

Die erhaltene Linienstruktur ist in Abb. 1 gezeigt. Der durch feldinduzierte Oxidation im Rasterkraftmikroskop erzeugte Graben hat eine Halbwertsbreite von 35 nm und eine Tiefe von 20 nm.

### Beispiel 2

Dieses Beispiel betrifft das vollständige Abtragen einer 250 nm dicken amorphen Kohlenstoffschicht in einem ausgewählten Bereich. Die Kohlenstoffschicht befindet sich hierbei auf einem Silizium-Einkristall-Substrat und wird mittels eines kommerziellen Rasterkraftmikroskopes abgetragen, indem der abzutragende Bereich unter 12 Volt Gleichspannung mit 3 µm/s abgerastert wird.

Das Rasterkraftmikroskop-Bild gemäß Abb. 2 zeigt das Ergebnis der erfolgten Strukturierung. Die Stufenhöhe in der Rasterkraftmikroskop-Abbildung stimmt mit der mit dem Profilometer bestimmten Schichtdicke des amorphen Kohlenstoffs überein.

### Beispiel 3

Dieses Beispiel betrifft die Erzeugung einer schmalen Unterbrechung einer AuPd-Leiterbahn unter Verwendung einer durch lokale feldinduzierte Oxidation im Rasterkraftmikroskop hergestellten Ätzmaske aus amorphem Kohlenstoff.

Hierbei wurde eine durch optische und Elektronenstrahl-Lithographie gefertigte Leiterbahnstruktur mit einer amorphen Kohlenstoffschicht von etwa 8 nm Schichtdicke überzogen. Dazu wurde der Kohlenstoff durch Sputtern von einem Graphittiegel mit Krypton als Arbeitsgas abgeschieden. In dieser Schicht wurde dann mit dem erfindungsgemäßen Verfahren zur lokalen Oxidation von Filmen aus amorphem Kohlenstoff über eine der Leiterbahnen ein schmaler Graben in einem Winkel von etwa 60 Grad zu dieser Leiterbahn geschrieben. Die Kohlenstoffschicht diente als Ätzmaske für das anschließende Argon-Ionen-Ätzen, so daß die Leiterbahn nur an der Stelle geätzt wurde, an der sie nicht von Kohlenstoff bedeckt war. Der Ätzprozeß wurde während des Ätzens mittels einer Messung des elektrischen Widerstandes der Leiterbahn kontrolliert.

In Abb. 3 ist das Ergebnis der Strukturierung gezeigt. Die Leiterbahnunterbrechung ist etwa 30 nm breit.

## Patentansprüche

1. Verfahren zur Nanostrukturierung von amorphen Kohlenstoffschichten, **dadurch gekennzeichnet, daß** mit einer elektrisch leitfähigen oder halbleitenden Sonde, die sich in einem Abstand, in dem der elektrische Leitungsmechanismus der Feldemission oder des Tunnelns möglich ist, über der amorphen Kohlenstoffschicht befindet oder über diese geführt wird, und an die eine elektrische Spannung gegenüber der Schicht angelegt wird, an den Stellen, an denen Vertiefungen in die Schicht eingebracht oder die Schicht entfernt werden soll, eine lokale, feldinduzierte Reaktion des Kohlenstoffs aktiviert wird, wobei die Reaktionsprodukte flüchtig sind.

2. Verfahren nach Anspruch 1, **dadurch gekennzeichnet, daß** die elektrisch leitfähige oder halbleitende Sonde in einem Abstand von bis zu 10 nm über der amorphen Kohlenstoffschicht befindet oder über diese geführt wird.

3. Verfahren nach Anspruch 1, **dadurch gekennzeichnet, daß** an die Sonde ein negatives Gleichspannungspotential mit einer Mindestspannung im Bereich von 3 bis 8 Volt gegenüber der Schicht oder eine Wechselspannung angelegt wird.

4. Verfahren nach Anspruch 1 oder 2, **dadurch gekennzeichnet, daß** der Abstand zwischen der elektrisch leitfähigen oder halbleitenden Sonde und der amorphen Kohlenstoffschicht durch eine elektrisch isolierende Schicht von bis zu einigen Nanometern Schichtdicke, die sich auf der Oberfläche der Sonde befindet, definiert wird.

5. Verfahren nach Anspruch 1, **dadurch gekennzeichnet, daß** die Reaktion in einer Sauerstoffumgebung durchgeführt wird, wobei als Reaktionsprodukte Oxide des Kohlenstoffs entstehen.

6. Verfahren nach Anspruch 1, **dadurch gekennzeichnet, daß** die Reaktion in einer Wasserstoff- oder einer Stickstoffumgebung durchgeführt wird.

7. Verfahren nach Anspruch 1, **dadurch gekennzeichnet, daß** die Nanostrukturierung mittels eines Rastersondenmikroskops durchgeführt wird, wobei die elektrisch leitende oder halbleitende Sonde des Mikroskops zur feldinduzierten Reaktion des Kohlenstoffs verwendet wird.

8. Verfahren nach Anspruch 1, **dadurch gekennzeichnet, daß** als elektrisch leitfähige Sonde eine strukturierte Elektrode verwendet wird, deren Struktur als das Negativ der in der Schicht zu erzielenden Nanostruktur ausgeführt ist.

9. Verfahren nach Anspruch 1, **dadurch gekennzeichnet, daß** der Abstand zwischen der elektrisch leitfähigen oder halbleitenden Sonde und der amorphen Kohlenstoffschicht während der Strukturierung zeitlich periodisch verändert wird.

10. Verfahren nach Anspruch 3, **dadurch gekennzeichnet, daß** das negative Gleichspannungspotential während der Strukturierung zeitlich periodisch verändert wird.

11. Verfahren nach Anspruch 1 und 3, **dadurch gekennzeichnet, daß** eine elektrisch leitfähige oder halbleitende Sonde aus Silizium verwendet wird und daß die Polarität des Gleichspannungspotentials während der Strukturierung in bestimmten Intervallen für bestimmte Zeit umgekehrt wird, wodurch auf der Oberfläche der Sonde durch feldinduzierte Oxidation eine Schicht Siliziumoxid entsteht oder wiederhergestellt wird.

12. Verfahren nach Anspruch 3, **dadurch gekennzeichnet, daß** statt einer Gleichspannungsquelle eine Konstantstromquelle verwendet wird, wobei der Übergangswiderstand zwischen elektrisch leitfähiger oder halbleitender Sonde und der amorphen Kohlenstoffschicht so einzustellen ist, daß während der Strukturierung eine bestimmte Mindestspannung erreicht wird.

13. Verfahren nach einem oder mehreren der Ansprüche 1 bis 12, **dadurch gekennzeichnet, daß** das Verfahren zum Erzeugen von Strukturen, die digitale oder analoge Informationen repräsentieren, für den Zweck der Speicherung solcher Informationen in amorphen Kohlenstoffschichten angewandt wird.

## Claims

1. Process for nanostructuring amorphous carbon layers, **characterized in that** an electrically conductive or semiconducting probe, which is located above or guided over the amorphous carbon layer at a distance within which the electrical conduction mechanism of field emission or tunnelling is possible, and to which an electric voltage is applied with respect to the layer, is used to activate a local, field-induced reaction of the carbon at the locations at which recesses are to be introduced into the layer or the layer is to be removed, the reaction products being volatile.

2. Process according to Claim 1, **characterized in that** the electrically conductive or semiconducting probe is located above or guided over the amorphous carbon layer at a distance of up to 10 nm.

3. Process according to Claim 1, **characterized in that** a negative DC voltage potential with a minimum voltage in the range from 3 to 8 volts with respect to the layer or an AC voltage is applied to the probe.

4. Process according to Claim 1 or 2, **characterized in that** the distance between the electrically conductive or semiconducting probe and the amorphous carbon layer is defined by an electrically insulating layer with a layer thickness of up to a few nanometres, which is located on the surface of the probe.

5. Process according to Claim 1, **characterized in that** the reaction is carried out in an oxygen environment, with oxides of carbon being produced as reaction products.

6. Process according to Claim 1, **characterized in that** the reaction is carried out in a hydrogen or nitrogen environment.

7. Process according to Claim 1, **characterized in that** the nanostructuring is carried out by means of a scanning probe microscope, with the electrically conductive or semiconducting probe of the microscope being used for the field-induced reaction of the carbon.

8. Process according to Claim 1, **characterized in that** the electrically conductive probe used is a structured electrode, the structure of which is designed as the negative of the nanostructure which is to be produced in the layer.

9. Process according to Claim 1, **characterized in that** the distance between the electrically conductive or semiconducting probe and the amorphous carbon layer is altered periodically at times during the structuring.

10. Process according to Claim 3, **characterized in that** the negative DC voltage potential is altered periodically at times during the structuring.

11. Process according to Claims 1 and 3, **characterized in that** an electrically conductive or semiconducting probe made from silicon is used, and **in that** the polarity of the DC voltage potential is reversed for a certain time at certain intervals during the structuring, with the result that a layer of silicon oxide is formed or restored on the surface of the probe as a result of field-induced oxidation.

12. Process according to Claim 3, **characterized in that** a constant current source is used instead of a DC voltage source, in which case the contact resistance between electrically conductive or semiconducting probe and the amorphous carbon layer is to be set in such a way that a certain minimum voltage is reached during the structuring.

13. Process according to one or more of Claims 1 to 12, **characterized in that** the process is used to produce structures which represent digital or analogue information items for the purpose of storing information items of this type in amorphous carbon layers.

## Revendications

1. Procédé de nanostructuration de couches de carbone amorphes, **caractérisé en ce que**, par une sonde électriquement conductrice ou semi-conductrice, qui se trouve au-dessus de la couche de carbone amorphe ou est conduite au-dessus de celle-ci à une distance à laquelle le mécanisme de conduction électrique de l'émission par effet de champ ou du tunnel est possible et sur laquelle une tension électrique est appliquée par rapport à la couche, une réaction locale du carbone induite par effet de champ, est activée aux endroits où des évidements dans la couche doivent être introduits ou la couche doit être éliminée, les produits réactionnels étant volatils.

2. Procédé suivant la revendication 1, **caractérisé en ce que** la sonde électriquement conductrice ou semi-conductrice se trouve au-dessus de la couche de carbone amorphe ou est guidée au-dessus de celle-ci à une distance de jusqu'à 10 nm.

3. Procédé suivant la revendication 1, **caractérisé en ce que**, à la sonde, un potentiel de tension continue négatif présentant une tension minimale de l'ordre de 3 à 8 volts par rapport à la couche ou une tension alternative est appliqué.

4. Procédé suivant la revendication 1 ou 2, **caractérisé en ce que** la distance entre la sonde électriquement conductrice ou semi-conductrice et la couche de carbone amorphe est définie par une couche électriquement isolante d'une épaisseur allant jusqu'à quelques nanomètres, laquelle se trouve sur la surface de la sonde.

5. Procédé suivant la revendication 1, **caractérisé en ce que** la réaction est effectuée dans un environnement d'oxygène, des oxydes du carbone étant obtenus comme produits réactionnels.

6. Procédé suivant la revendication 1, **caractérisé en ce que** la réaction est effectuée dans un environnement d'hydrogène ou d'azote.

7. Procédé suivant la revendication 1, **caractérisé en ce que** la nanostructuration est effectuée au moyen d'un microscope à sonde de balayage, la sonde électriquement conductrice ou semi-conductrice du microscope étant utilisée pour la réaction induite par effet de champ du carbone.

8. Procédé suivant la revendication 1, **caractérisé en ce que**, comme sonde électriquement conductrice, on utilise une électrode structurée dont la structure est exécutée sous la forme du négatif de la nanostructure à obtenir dans la couche.

9. Procédé suivant la revendication 1, **caractérisé en ce que** la distance entre la sonde électriquement conductrice ou semi-conductrice et la couche de carbone amorphe est, pendant la structuration, modifiée de manière périodique dans le temps.

10. Procédé suivant la revendication 3, **caractérisé en ce que** le potentiel de tension continue négatif est, pendant la structuration, modifié de manière périodique dans le temps.

11. Procédé suivant la revendication 1 et 3, **caractérisé en ce qu'**on utilise une sonde électriquement conductrice ou semi-conductrice en silicium et **en ce que** la polarité du potentiel de tension continue est, pendant la structuration, inversée à des intervalles déterminés pendant un temps déterminé, ce qui permet de former ou de reconstruire sur la surface de la sonde une couche d'oxyde de silicium par oxydation induite par effet de champ.

12. Procédé suivant la revendication 3, **caractérisé en ce que**, au lieu d'une source de tension continue, on utilise une source de courant constant, la résistance de passage entre la sonde électriquement conductrice ou semi-condutrice et la couche de carbone amorphe étant à ajuster de façon que l'on obtienne pendant la structuration une tension minimale déterminée.

13. Procédé suivant une ou plusieurs des revendications 1 à 12, **caractérisé en ce que** le procédé pour produire des structures, qui représentent des informations numériques ou analogues, est appliqué en vue du stockage de telles informations dans des couches de carbone amorphes.
